# FASCICULE DE BREVET EUROPEEN

(11) **EP 3 551 923 B1**
(45) Date de publication et mention de la délivrance du brevet: **19.07.2023**
(21) Numéro de dépôt: 17817807.5
(22) Date de dépôt: 04.12.2017
(51) Int. Cl.: C23C 14/00, C23C 14/06

(54) **PIÈCE DE FROTTEMENT, SYSTÈME MÉCANIQUE COMPRENANT UNE TELLE PIÈCE DE FROTTEMENT, ET PROCÉDÉ DE MISE EN OEUVRE.**
REIBUNGSTEIL, MECHANISCHES SYSTEM MIT SOLCH EINEM REIBUNGSTEIL UND VERFAHREN ZUR IMPLEMENTIERUNG
FRICTION PIECE, MECHANICAL SYSTEM COMPRISING SUCH A FRICTION PIECE AND METHOD OF IMPLEMENTATION

(30) Priorité: 07.12.2016 FR 1662033
(43) Date de publication de la demande: 16.10.2019
(73) Titulaire: HYDROMECANIQUE ET FROTTEMENT, 42162 Andrézieux-Bouthéon (FR)
(72) Inventeur: HEAU, Christophe, 42100 Saint Etienne (FR); MAURIN-PERRIER, Philippe, 42680 Saint Marcellin en Forez (FR)
(74) Mandataire: Cabinet Laurent & Charras
(86) Numéro de dépôt international: PCT/FR2017/053377
(87) Numéro de publication internationale: WO 2018/104641

(56) Documents cités:
- FR-A1- 2 594 143
- US-A- 5 618 590
- US-A1- 2015 018 254
- LIU Y ET AL: "Evaluation of the friction of WC/DLC solid lubricating films in vacuum", TRIBOLOGY INTERNATIONAL, ELSEVIER, AMSTERDAM, NL, vol. 39, no. 12, 1 décembre 2006 (2006-12-01), pages 1584-1590, XP027881436, ISSN: 0301-679X [extrait le 2006-12-01]

## Description

La présente invention concerne une pièce de frottement, susceptible d'être sollicitée à hautes températures en milieu lubrifié. L'invention concerne également un système mécanique comprenant une telle pièce. L'invention concerne également un procédé de mise en oeuvre d'une telle pièce.

Le domaine de l'invention est celui des pièces de frottement métalliques revêtues d'une couche mince, permettant une réduction du frottement en milieu lubrifié.

A titre d'exemple non limitatif, la pièce de frottement peut être un segment de moteur automobile, et plus particulièrement le segment coupe-feu. En pratique, les segments sont soumis à des températures de fonctionnement supérieures à 200°C, en milieu lubrifié susceptible d'être appauvri.

Selon d'autres exemples non limitatifs, le revêtement en couche mince peut être appliqué sur un axe de piston, une jupe de piston, toute autre partie de piston, ou toute autre pièce qui pourrait être soumise à un fonctionnement à température élevée.

Dans les applications industrielles, la présence d'un film lubrifiant séparant deux pièces de frottement permet d'obtenir de faibles niveaux d'usure, grâce à l'absence totale de contact entre ces deux pièces.

Dans certains cas, un film continu ne peut pas être maintenu dans la durée, ce qui provoque des interactions directes entre les deux pièces. La discontinuité du film lubrifiant est la caractéristique principale de la lubrification en "régime mixte" et en « régime limite ».

Dans l'industrie automobile, les revêtements en couche mince de DLC (« Diamond Like Carbon » en anglais) sont largement utilisés pour réduire le frottement entre pièces. En pratique, la réduction du frottement entre pièces revêtues de DLC intervient essentiellement dans le régime mixte de lubrification.

Une particularité essentielle des revêtements de DLC tient au fait que la rugosité des surfaces diminue au cours du temps et tend vers des valeurs particulièrement basses. Ainsi, la transition de la lubrification du régime limite vers le régime mixte, ou encore du régime mixte vers le régime hydrodynamique, se décale vers des valeurs plus basses de vitesse.

Contrairement aux surfaces revêtues de DLC, des surfaces en acier initialement polies voient leur rugosité augmenter dans le temps. En réagissant sur les surfaces, les additifs anti-usure de type ZDTP forment des ilots augmentant localement la rugosité.

Certains contacts lubrifiés opèrent de manière permanente à des températures supérieures à 200°C, et de manière transitoire à des températures encore plus élevées. Ces contacts sont assez mal lubrifiés, ce qui explique d'ailleurs les températures élevées qui y sont relevés.

Dans de telles conditions de fonctionnement, l'usure d'un revêtement de DLC est relativement rapide. On observe un comportement stochastique de cette usure, probablement dû au fait que la lubrification est assez faible et mal maîtrisée.

Le revêtement de DLC présente alors une usure par polissage et la couche de revêtement se consomme, suivant un mécanisme qui s'apparente à de l'oxydation. Le carbone et l'hydrogène de la couche de revêtement se combinent à l'oxygène ambient pour former de l'eau et du dioxyde de carbone. L'appauvrissement en lubrifiant et l'augmentation de température à l'interface de contact entre les pièces de frottement conduisent à une oxydation accélérée du revêtement de DLC, jusqu'à sa disparition. Le caractère mal maitrisé de la lubrification, combiné à des températures élevées, conduit ainsi à une augmentation de la vitesse d'usure.

Aujourd'hui, deux approches permettent de faire face aux problèmes ci-dessus.

La première approche consiste à utiliser des revêtements constitués d'alliage de chrome ou nitrures de chrome, qui présentent une résistance élevée dans des conditions de fonctionnement à haute température et lubrification pauvre, au sacrifice de la réduction du frottement. Cette approche correspond à des conceptions anciennes de systèmes mécaniques, tels que les segments coupe-feu de moteur automobile, couramment revêtus par des couches à base de chrome. Cette approche ne permet pas d'abaisser les pertes par frottement en comparaison avec un acier non revêtu, mais permet tout de même de protéger les surfaces contre l'usure et le grippage.

La seconde approche consisterait à améliorer la lubrification associée à un revêtement de DLC, ce qui permettrait une meilleure évacuation des calories et la protection du revêtement vis-à-vis de l'oxygène. Cette approche nécessiterait de modifier la conception des systèmes mécaniques pour distribuer le lubrifiant, ainsi que d'augmenter les débits de lubrifiant, et donc l'énergie consommée pour assurer la circulation de ce lubrifiant. En pratique, cette seconde approche n'est pas mise en oeuvre en raison des surcoûts de conception, et du fait que l'efficacité énergétique apportée par le revêtement serait contrebalancée par les efforts nécessaires pour avoir une lubrification abondante.

US5618590A décrit un segment de piston, comportant un revêtement dur formé par placage ionique, avec différentes combinaisons de matériaux envisageables.

FR2594143A1 au nom du Demandeur décrit un revêtement à propriétés de frottement améliorées, comprenant du carbure de tungstène et du cobalt. Au cours de ses travaux de recherche, le Demandeur a trouvé une alternative à ce revêtement.

Le but de la présente invention est de proposer une pièce de frottement améliorée, remédiant aux inconvénients ci-dessus.

A cet effet, l'invention a pour objet une pièce de frottement, comportant une surface métallique et une couche de revêtement externe, caractérisée en ce que la couche de revêtement externe est composée de carbure de tungstène dopé à l'azote WC(N) avec entre 5 et 12 % atomique d'azote, la couche de revêtement externe consiste en :
- entre 40 et 43 % atomique de carbone,
- entre 40 et 43 % atomique de tungstène,
- entre 5 et 12 % atomique d'azote,
- entre 7 et 9% atomique de cobalt,
- d'autres composés pour un total compris entre 0 et 8 % atomique.

Ainsi, l'invention permet de réduire le frottement subi par la couche de revêtement en milieu lubrifié, en particulier en régime de lubrification mixte, tout en améliorant sa résistance aux températures de sollicitation élevées, notamment supérieures à 200°C.

En comparaison avec un revêtement DLC, les matériaux de revêtement selon l'invention résistent bien mieux à l'usure à chaud, en raison de leur meilleure stabilité thermique et tenue à l'oxydation, tout en procurant un abaissement de frottement satisfaisant.

En comparaison avec un revêtement du type nitrure de chrome CrN ou carbure de tungstène WC (avec 6 % Co en masse), les matériaux de revêtement du type carbure de tungstène dopé à l'azote WC(N) selon l'invention permettent d'abaisser le frottement, tout en procurant une tenue à l'oxydation satisfaisante.

Certaines caractéristiques avantageuses de l'invention, prises isolément ou en combinaison, sont détaillées ci-après.

En pratique, la couche de revêtement externe est formée par pulvérisation sous vide d'une cible de carbure de tungstène WC, avec introduction d'un débit d'azote.

Le cobalt constitue un élément de la cible.

Classiquement, la fabrication de la pièce de frottement comprend une étape de décapage de la surface métallique à revêtir, notamment un décapage ionique, avant le dépôt de la couche de revêtement externe.

Selon un mode de réalisation particulier, la surface métallique est revêtue uniquement avec la couche de revêtement externe, en excluant la présence d'une sous-couche entre la surface métallique et la couche de revêtement externe.

En alternative, la surface métallique est revêtue avec au moins une sous-couche formée sous la couche de revêtement externe. Cette sous-couche est par exemple composée de chrome ou de nitrure de chrome.

L'invention a également pour objet un système mécanique, comprenant une première pièce de frottement telle que mentionnée ci-dessus, une seconde pièce de frottement disposée en contact lubrifié avec la première pièce de frottement, et un lubrifiant disposé à une interface de contact lubrifié entre les pièces de frottement.

Selon un mode de réalisation particulier, la seconde pièce de frottement est similaire à la première pièce de frottement. Autrement dit, la seconde pièce de frottement comporte une surface métallique et une couche de revêtement externe déposée sur la surface métallique, la couche de revêtement externe de la seconde pièce de frottement étant composée de carbure de tungstène dopé à l'azote WC(N) avec entre 5 et 12 % atomique d'azote, la couche de revêtement externe de la seconde pièce de frottement consistant en:
- entre 40 et 43 % atomique de carbone,
- entre 40 et 43 % atomique de tungstène,
- entre 5 et 12 % atomique d'azote,
- entre 7 et 9% atomique de cobalt,
- d'autres composés pour un total compris entre 0 et 8 % atomique.

De préférence, la couche de revêtement externe de la première pièce de frottement et la couche de revêtement externe de la seconde pièce de frottement ont la même composition.

En alternative, les couches de revêtement en regard peuvent avoir des compositions différentes, avec néanmoins 5 à 12 % atomique d'azote.

L'invention a également pour objet un procédé de mise en oeuvre d'une pièce de frottement telle que mentionnée ci-dessus. Le procédé est caractérisé en ce qu'il comprend des étapes consistant à :
- disposer une seconde pièce de frottement en contact lubrifié avec la pièce de frottement ;
- disposer un lubrifiant à une interface de contact lubrifié entre les pièces de frottement ; et
- actionner les pièces de frottement, de sorte que l'interface de contact lubrifié entre les pièces de frottement atteint une température supérieure à 200 °C.

L'invention sera mieux comprise à la lecture de la description qui va suivre, donnée uniquement à titre d'exemple non limitatif et faite en référence aux dessins annexés sur lesquels :
- la figure 1 est une représentation schématique partielle d'un système mécanique conforme à l'invention, en coupe transversale ;
- la figure 2 est une représentation analogue à la figure 1, montrant un système mécanique conforme à un deuxième mode de réalisation de l'invention ;
- la figure 3 est une représentation analogue à la figure 1, montrant un système mécanique conforme à un troisième mode de réalisation de l'invention
- la figure 4 est une représentation schématique d'un banc d'essai, utilisé pour identifier les matériaux de revêtement conformes à l'invention ;
- les figures 5, 6 et 7 sont des graphes illustrant différentes étapes d'identification des matériaux de revêtement conformes à l'invention.

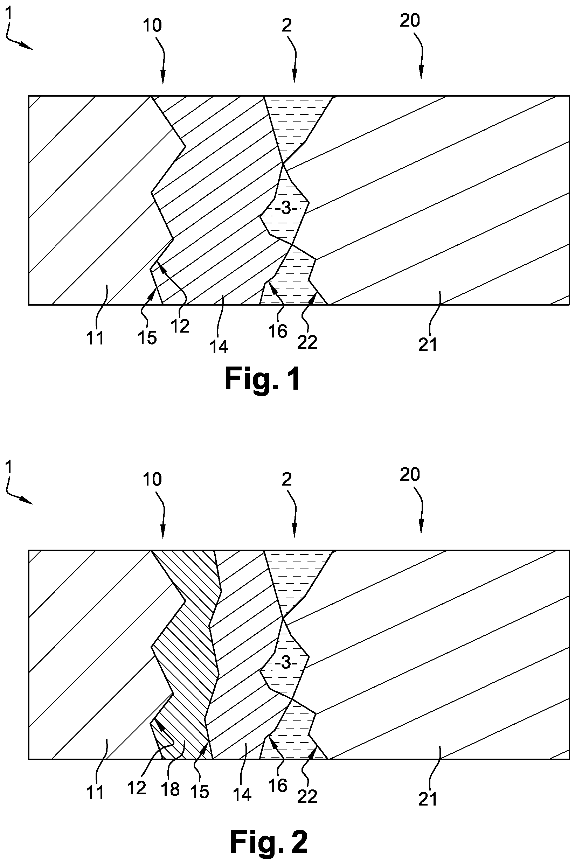

Sur la figure 1 est représenté, partiellement et schématiquement, un système mécanique 1 conforme à l'invention.

Le système mécanique 1 comprend deux pièces de frottement 10 et 20 séparées par un lubrifiant 3 à leur interface de contact 2. En pratique, cette interface 2 est soumise à des températures de fonctionnement supérieures à 200°C. Dans ces conditions, le lubrifiant 3 est susceptible d'être appauvri.

Les pièces 10 et 20 sont animées d'un mouvement relatif en translation et/ou en rotation. Dans un but de simplification, les pièces 10 et 20 peuvent présenter toutes formes et agencement adaptés à l'application visée, autrement dit adaptés au type de système mécanique 1. Les pièces 10 et 20 sont en métal, de préférence en acier.

La pièce 10 comprend un corps 11, une surface externe 12, et une couche de revêtement externe 14 déposé sur la surface 12. La couche 14 présente une surface interne 15 et une surface externe 16. La surface 15 est solidarisée à la surface métallique 12 lors du dépôt de la couche 14. La surface 16 fait face à la pièce 20 au niveau de l'interface de contact lubrifié 2.

La pièce 20 comprend un corps 21 et une surface externe 22. La pièce 20 est dépourvue de couche de revêtement externe. La surface 22 fait face à la pièce 10 au niveau de l'interface de contact lubrifié 2.

En régime limite ou mixte, la surface 16 de la couche de revêtement 14 et la surface 22 de la pièce 20 sont en contact par endroits, à l'interface de contact lubrifié 2 entre les pièces 10 et 20. Ainsi, le lubrifiant 3 forme un film discontinu entre les surfaces 16 et 22, à l'interface 2.

Le lubrifiant 3 est choisi en fonction de l'application visée, autrement dit en fonction du type de système mécanique 1. A titre d'exemple, le lubrifiant 3 peut être un lubrifiant automobile du commerce, tel qu'une huile SAE 5W30 comportant des additifs classiques.

Selon l'invention, la couche de revêtement 14 est un composé de type carbure de tungstène dopé azote WC(N), avec entre 5 et 12 % atomique d'azote inclus.

En pratique, une telle couche de revêtement 14 est bien adaptée pour opérer en milieu lubrifié à des températures supérieures à 200°C. Ainsi, la pièce 10 comportant la couche de revêtement 14 est adaptée pour opérer en milieu lubrifié à des températures supérieures à 200 °C.

De façon inattendue, le dopage de couches de carbure de tungstène par de l'azote conduit à une réduction de frottement en milieu lubrifié, par rapport aux matériaux conventionnels dont le carbure de tungstène WC non dopé ou faiblement dopé (% atomique d'azote inférieur à 5 %).

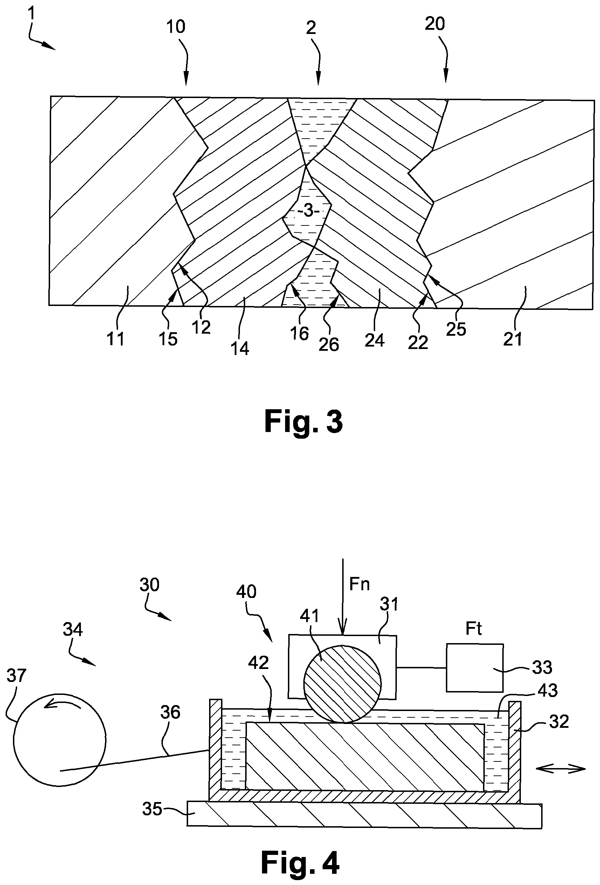

Sur les figures 2 et 3 sont représentés, partiellement et schématiquement, des systèmes mécaniques 1 conformes à d'autres modes de réalisation de l'invention. Les éléments constitutifs du système 1, qui sont similaires au premier mode de réalisation, portent les mêmes références numériques. Seules les différences avec le premier mode de réalisation sont détaillées ci-après.

Sur la figure 2, la pièce 10 comporte une sous-couche 18 formée entre le corps 11 et la couche de revêtement 14. La surface 12 est revêtue avec la sous-couche 18, puis avec la couche de revêtement 14. A titre d'exemples non limitatifs, la sous-couche peut être composée de chrome ou de nitrure de chrome. Le nitrure de chrome peut être déposé par pulvérisation cathodique magnétron réactive.

Sur la figure 3, la pièce 20 comporte une couche de revêtement externe 24 déposée sur la surface 22. La couche 24 présente une surface interne 25 et une surface externe 26. La surface 25 est solidarisée à la surface métallique 22 lors du dépôt de la couche 24. La surface 26 fait face à la pièce 10 au niveau de l'interface de contact lubrifié 2. Le lubrifiant 3 forme un film discontinu entre les surfaces 16 et 26 des couches de revêtement 14 et 24, à l'interface de contact lubrifié 2 entre les pièces 10 et 20.

Selon un mode de réalisation particulier, la pièce 20 est également conforme à l'invention. Autrement dit, la couche de revêtement externe 24 a une composition de type carbure de tungstène dopé azote WC(N) avec entre 5 et 12 % atomique d'azote. Dans ce cas particulier, où les deux surfaces 12 et 22 des pièces 10 et 20 sont revêtues, les couches 14 et 24 ont de préférence une composition similaire.

En alternative, la pièce 20 peut comporter une couche de revêtement externe 24 ayant une composition différente de la couche 14.

Par ailleurs, la pièce 20 peut comporter une sous-couche formée entre le corps 21 et la couche de revêtement 24, comme décrit ci-dessus pour la pièce 10 en référence à la figure 2.

La méthode d'identification de matériaux de revêtement susceptibles de résister dans des conditions de lubrification et de haute température est détaillée ci-après.

Cette méthode consiste à déposer une couche de revêtement sur des éprouvettes en acier, puis caractériser les différents revêtements, d'une part, par frottement dans un lubrifiant et, d'autre part, par résistance à une température de 350°C.

Les matériaux de revêtement testés sont les suivants : nitrure de chrome CrN, carbure de tungstène WC, carbures de tungstène dopés à l'azote WC(N), DLC type a-C:H.

Préalablement aux dépôts de revêtement, toutes les éprouvettes subissent les mêmes étapes de préparation. Les éprouvettes sont dégraissées et positionnées sur un porte échantillon rotatif animé d'un mouvement planétaire, selon l'état de l'art des dépôts sous vide de couches minces dures. On procède au pompage de l'enceinte à vide. Le pompage est effectué en même temps qu'un chauffage à 150°C qui permet d'activer les phénomènes de désorption et d'améliorer la qualité du vide. Au bout de 2h30 de chauffage, on s'assure que la pression mesurée par une jauge Penning est inférieure à 2×10⁻⁵ mbar. On procède alors au décapage ionique des éprouvettes en acier dans un plasma d'argon, pendant une heure sous une tension de -150V appliquée aux éprouvettes. A l'issue du décapage, l'oxyde de passivation des éprouvettes a disparu et les surfaces sont aptes à recevoir un dépôt.

Le dépôt de nitrure de chrome est réalisé par pulvérisation cathodique magnétron réactive. Pendant la fin du décapage ionique de l'éprouvette, la cathode magnétron est allumée sous 5kW derrière un cache de pré-pulvérisation pour nettoyer sa surface pendant 5 minutes. A la fin du décapage, on maintient le plasma d'assistance ionique, on abaisse la tension de polarisation à -50V et on ouvre le cache de sorte que l'on commence à déposer une fine couche de chrome. Pendant le dépôt de cette couche, on mesure l'intensité émise par les atomes de chrome dans le plasma à une longueur d'onde de 520 nm. Cette intensité lumineuse est normée à 100 et on introduit un débit d'azote jusqu'à ce que la lumière émise par le chrome diminue à une valeur de 50 % de l'intensité émise en argon pur. En 3h de dépôt, on obtient ainsi une couche de CrN de 2,7 µm d'épaisseur et d'une dureté de 1900 Hv sous 10 mN.

Le dépôt de carbure de tungstène est réalisé par pulvérisation d'une cible de carbure de tungstène à 6 % de liant cobalt en masse. La cible est nettoyée sous cache pendant 5 minutes en fin de décapage ionique. Une fois le décapage ionique terminé, on éteint le plasma d'assistance ionique et on ouvre le cache de pré-pulvérisation pour débuter le dépôt de WC. En 3h de dépôt, on obtient une couche de 2,1 µm d'épaisseur et d'une dureté de 1900 Hv sous 10 mN.

Les dépôts de carbure de tungstène dopés en azote sont réalisés en introduisant un débit de gaz réactif dans le flux pulvérisé.

Quel que soit le débit d'azote à partir de 60 sccm d'azote, la composition de la couche de revêtement est stable et des analyses EDX indiquent une composition comportant 40 at.% de carbone, 12 at.% d'azote, 8 at.% de cobalt et 40 at.% de tungstène. Dans ces conditions, les dépôts dopés à l'azote présentent une dureté de 2900 Hv, nettement plus élevée que celle d'un dépôt de WC sans gaz réactif.

Les caractéristiques des dépôts sont résumées dans le Tableau 1 ci-après. Les dépôts notés de WC0 à WC4 sont effectués à débit d'azote croissant jusqu'à saturation en azote (60 sccm dans le cas particulier des conditions de dépôt utilisées ici).

**Tableau 1 - dépôts de carbure de tungstène dopés en azote**

| Référence | % at N | % at Co | % at W | % at C | Hv en kg.mm⁻² | E' en GPa | Conformité |
|---|---|---|---|---|---|---|---|
| WC0 | 0 | 10 | 45 | 45 | 2200 | 270 | NC |
| WC1 | 2 | 10 | 44 | 44 | 2400 | 290 | NC |
| WC2 | 5 | 9 | 43 | 43 | 2850 | 305 | C |
| WC3 | 9 | 9 | 41 | 41 | 2950 | 310 | C |
| WC4 | 12 | 8 | 40 | 40 | 2900 | 315 | C |

Enfin, le dépôt de DLC type a-C:H est réalisé par combinaison d'une technologie de dépôt PVD pour déposer une sous-couche à base de WC, qu'on enrichit progressivement en carbone pour obtenir une composition propre à promouvoir l'adhérence de la couche de DLC élaborée en PACVD, tel que décrit dans le document WO2012/156647. Le dépôt ainsi obtenu se compose d'une couche à base de W de 0,8 µm d'épaisseur, sur laquelle on a déposé une couche de 2,2 µm de DLC. L'épaisseur totale de dépôt est de 3µm et la dureté superficielle est de 3200 Hv.

Les figures 4 à 7 illustrent un premier test de caractérisation, consistant à réaliser une série d'essais tribologiques sur les éprouvettes.

La figure 4 est une représentation schématique d'un banc d'essai 30, constituant un tribomètre. L'objectif de la série d'essais est de démontrer le potentiel de matériaux de revêtement particuliers à réduire le frottement en milieu lubrifié, en comparaison avec un contact acier/acier. Afin de ne tester que les effets des revêtements, on s'assure que les essais soient réalisés dans les mêmes conditions. En particulier, l'ensemble des éprouvettes présente une rugosité initiale identique.

Le banc d'essai 30 est utilisé pour caractériser le frottement au sein d'un système mécanique 40 constitué par deux éprouvettes 41 et 42 en acier, à savoir un cylindre 41 et un disque 42. Les essais successifs mettent en oeuvre plusieurs systèmes 40, et donc plusieurs éprouvettes 41 et 42. Dans un système 40 de référence, les éprouvettes 41 et 42 ne reçoivent pas de revêtement, ce qui permet de caractériser le contact acier/acier. Dans chacun des autres systèmes 40, les éprouvettes 41 et 42 reçoivent le même matériau de revêtement. Le test de deux éprouvettes 41 et 42 revêtues frottant l'une contre l'autre correspond à la configuration de la figure 3..

Les cylindres 41 utilisés pour les essais sont des rouleaux cylindriques en acier 100Cr6, provenant d'un roulement à rouleaux. Les cylindres 41 présentent un diamètre de 10 mm. La surface des cylindres 41 est polie sur au moins une génératrice jusqu'à obtenir une rugosité moyenne arithmétique Ra < 0,02 µm, puis cette génératrice est revêtue avec le matériau à tester.

Les disques 42 utilisés pour les essais présentent un diamètre de 25 mm et une épaisseur de 5 mm. Une surface plane de chaque disque 42 est polie jusqu'à obtenir une rugosité moyenne arithmétique Ra < 0,02 µm, puis revêtue avec le matériau à tester.

Pour réaliser un essai, on installe le disque 42 dans une cuve 32 remplie avec un lubrifiant automobile du commerce, en l'espèce une huile 43 du type SAE 5W30 comportant des additifs classiques. Cette huile 43 permet d'obtenir un coefficient de frottement de l'ordre de 0,12-0,13 pour un contact acier/acier en régime limite de lubrification. Le disque 42 est fixé dans la cuve 32 en étant immergé dans l'huile 43.

Le cylindre 41 est monté sur un support 31 suspendu par des lames souples en acier, qui permettent un auto-alignement du cylindre 41 avec la surface polie du disque 42 lorsque les éprouvettes 41 et 42 sont mises en contact. Ce système d'auto-alignement est essentiel à la bonne conduite des essais, car il assure que la géométrie du contact entre les éprouvettes 41 et 42 est parfaitement maitrisée, de sorte qu'elle n'induit pas de biais sur la mesure de frottement. L'alignement des éprouvettes 41 et 42 dans un contact cylindre sur plan est la difficulté principale de ces essais.

Le support 31 du cylindre 41 est relié au reste du tribomètre par le biais d'un capteur piézoélectrique 33, placé en regard du contact lubrifié entre la génératrice revêtue du cylindre 41 et la surface plane revêtue du disque 42. Le capteur 33 permet de mesurer l'effort tangentiel Ft, à partir duquel le coefficient de frottement est déterminé.

L'interface de contact lubrifié entre le cylindre 41 et le disque 42 mesure 4 mm de longueur le long de la génératrice et 35 µm de largeur de contact dans la direction de frottement. En appliquant une charge normale Fn égale à 21 N, on obtient une pression de contact égale à 200 MPa. Outre l'alignement des éprouvettes 41 et 42, la pression de contact est un élément essentiel pour déterminer le coefficient de frottement.

Du point de vue cinématique, le cylindre 41 s'use plus vite que le disque 42, indépendamment de la nature du matériau de revêtement. Ainsi, il est crucial de s'assurer que le cylindre 41 ne présente aucune usure notable à l'issue de l'essai. En effet, une usure du cylindre 41 après essai induirait une diminution de la pression de contact par élargissement de l'aire de contact. L'abaissement du frottement constaté ne serait donc plus uniquement lié au matériau de revêtement, mais aussi à la chute de pression de contact liée à l'usure. Afin d'éviter cet écueil, on procède à un léger polissage du disque 42 revêtu par du papier abrasif SiC de grade 1200. Ce polissage élimine les pics de la surface, ce qui induit une réduction remarquable de la vitesse d'usure du cylindre 41. On vérifie à l'issue de l'essai la largeur de la trace de frottement. L'essai est rejeté si la largeur de cette trace dépasse 45 µm. Dans l'ensemble des résultats présentés, la largeur de la trace de frottement est comprise entre 35 et 45 µm, indiquant qu'aucune usure notable n'est intervenue et donc que le frottement est bien provoqué par la nature des matériaux de revêtement.

Le disque 42 est mobile en translation suivant un mouvement linéaire alternatif, grâce à un mécanisme de translation 34. En l'espèce, le disque 42 est fixé dans la cuve 32, qui est posée sur un rail à billes 35 et reliée par une tige 36 à un élément excentrique 37 mobile en rotation. L'élément excentrique 37 est entraîné en rotation par un moteur, non représenté dans un but de simplification. Ce mécanisme 34 permet de communiquer à la cuve 32 et donc au disque 42 un mouvement linéaire alternatif sur une course de 10 mm, suivant une loi sinusoïdale.

L'huile 43 est chauffée à 110°C dans la cuve 32, puis le mécanisme 34 entraîne la cuve 32 selon le mouvement de va-et-vient. On réalise un essai préliminaire de 1 heure sous une charge normale Fn de 21 N, avec une vitesse de rotation de l'élément excentrique 37 de 300 tours par minute. Cet essai préliminaire sert à roder les surfaces et à stabiliser le frottement.

Après obtention du frottement stabilisé, on réalise des essais de 3 minutes à des vitesses de rotation de l'élément excentrique 37 de 300, 450, 600 et 750 tours par minute. A partir de ces essais on extrait l'évolution du coefficient de frottement en fonction de la vitesse de translation du disque 42.

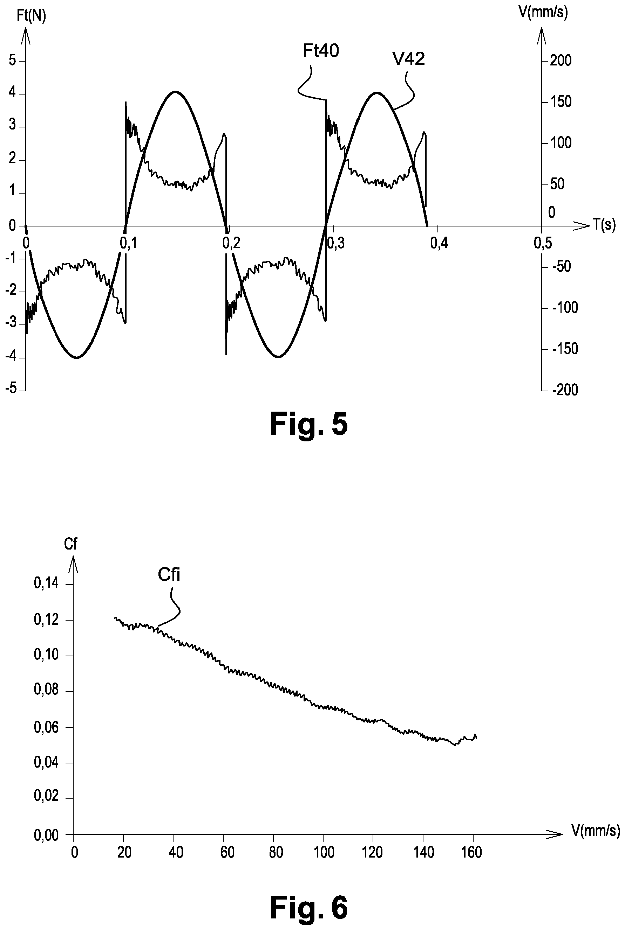

La figure 5 est un graphe illustrant une mesure réalisée avec le capteur piézoélectrique 33 équipant le banc d'essai 30, pour un matériau de revêtement donné.

L'axe des abscisses représente le temps T en secondes. L'axe gauche des ordonnées représente la force tangentielle Ft en newtons. L'axe droit des ordonnées représente la vitesse V de translation du disque 42 en mm/s.

Sur le graphe de la figure 5 sont représentées une courbe sinusoïdale V42 représentant la vitesse V de translation du disque 42 et une courbe Ft40 représentant la force tangentielle Ft mesurée par le capteur 33, en fonction du temps T.

Sur le graphe de la figure 6 est représentée une courbe Cfi représentant l'évolution du coefficient de frottement Cf en fonction de la vitesse V instantanée de translation du disque 42, à partir des mesures réalisées pour un matériau de revêtement donné.

L'axe des abscisses représente la vitesse V instantanée en mm/s obtenue à partir de la courbe V42, tandis que l'axe des ordonnées représente le coefficient de frottement Cf instantané déterminé à partir de la courbe Ft40.

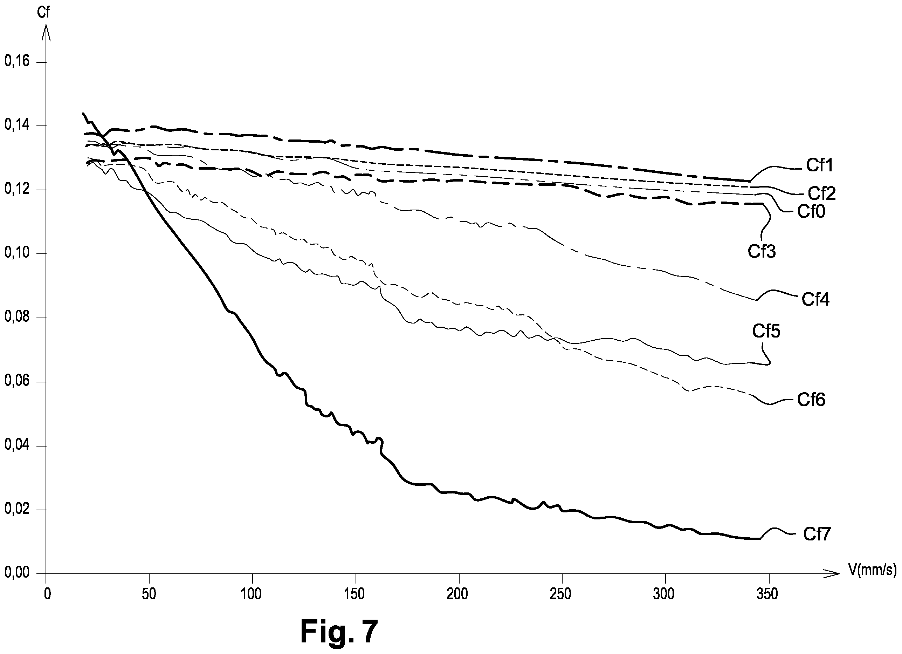

La figure 7 est un graphe illustrant l'évolution du coefficient de frottement Cf pour différents matériaux de revêtement. Chacune des courbes représentées sur ce graphe correspond à la courbe Cfi de la figure 6, pour un matériau de revêtement donné.

L'axe des abscisses représente la vitesse V instantanée en mm/s, tandis que l'axe des ordonnées représente le coefficient de frottement Cf instantané.

Sur le graphe de la figure 7 sont représentées :
- une courbe de référence Cf0 correspondant au résultat obtenu avec des éprouvettes 41 et 42 non revêtues (contact acier/acier) ;
- une courbe Cf1 obtenue avec des éprouvettes 41 et 42 revêtues de nitrure de chrome (contact CrN/CrN) ;
- une courbe Cf2 obtenue avec des éprouvettes 41 et 42 revêtues de carbure de tungstène non dopé de référence WC0 (contact WC/WC) ;
- une courbe Cf3 obtenue avec des éprouvettes 41 et 42 revêtues de WC dopé azote à 2 % atomique de référence WC1 (contact WC(N)/WC(N)) ;
- une courbe Cf4 obtenue avec des éprouvettes 41 et 42 revêtues de carbure de tungstène dopé à l'azote à 5 % atomique de référence WC2 (contact WC(N)/WC(N)) ;
- une courbe Cf5 obtenue avec des éprouvettes 41 et 42 revêtues de carbure de tungstène dopé à l'azote à 9 % atomique de référence WC3 (contact WC(N)/WC(N)) ;
- une courbe Cf6 obtenue avec des éprouvettes 41 et 42 revêtues de carbure de tungstène dopé à l'azote à 12 % atomique de référence WC4 (contact WC(N)/WC(N)) ;
- une courbe Cf7 obtenue avec des éprouvettes 41 et 42 revêtues de DLC de type a-C:H (contact DLC/DLC).

Deux types d'évolutions du coefficient de frottement Cf peuvent être distingués sur la figure 7.

Un premier groupe de matériaux comprend l'acier, le CrN, le WC non dopé et le WC(N) faiblement dopé (% atomique d'azote inférieur à 5 %). Ces matériaux se caractérisent par un coefficient de frottement Cf supérieur à 0,12, qui diminue assez peu lorsque la vitesse V de glissement augmente. Ce niveau de frottement est assez typique du régime de lubrification limite et du cisaillement des films réactionnels antiusure qui poussent sur les surfaces (tribofilms), formés à partir des additifs ZnDTP contenu dans l'huile 43. Le ZnDTP peut se décomposer en réagissant sur une surface et former un tribofilm de polyphosphates de Zn. Bien que les surfaces de frottement soient initialement polies, le frottement en régime limite de lubrification est induit par la rugosité des tribofilms générés sous forme d'ilots. L'observation des plans et des cylindres en microscopie optique révèle la présence de ces ilots, de couleur bleu et brune selon leur épaisseur.

Un second groupe de matériaux comprend les couches de WC dopé azote dont la teneur en azote atteint ou dépasse 5 % atomique, correspondant aux références WC2, WC3, WC4 et le DLC de type a-C:H. Ces matériaux se caractérisent par un coefficient de frottement Cf qui diminue quand la vitesse V de glissement augmente. Ce comportement est typique du régime mixte de lubrification. La réduction de frottement dans ce régime est permise par le fait que les surfaces de frottement restent lisses à l'issue de l'essai. La vitesse à laquelle le coefficient de frottement diminue est à l'image de la rugosité des éprouvettes après essai. De tous les matériaux testés ici, le DLC est celui qui induit le plus fort abaissement de frottement. L'observation des surfaces de frottement après essai ne montre pas de façon évidente la présence de tribofilms. Ces films sont soit absents soit d'épaisseur nettement moindre que les tribofilms classiques. Une épaisseur moindre conduit à limiter la rugosité sur les surfaces initialement polies, puisque c'est la structure en ilots et l'épaisseur qui produisent de la rugosité.

Pour le DLC, c'est probablement sa nature non métallique qui conduit à la faible affinité vis-à-vis du ZnDTP. Le dopage du carbure de tungstène par de l'oxygène ou de l'azote semble réduire considérablement l'affinité du ZnDTP. De façon inattendue, l'ajout d'azote dans un dépôt de WCCo au-delà de 5 % atomique d'azote conduit à un abaissement du frottement en comparaison avec les couches non dopées ou faiblement dopées.

Un second test de caractérisation des matériaux de revêtement est réalisé à l'aide d'éprouvettes planes revêtues.

Le test consiste à chauffer les éprouvettes à 350°C dans l'air pendant 2h. On mesure l'épaisseur de la couche de revêtement avant chauffage, puis après chauffage, pour vérifier que le matériau est resté intègre. Le choix d'une température de 350°C permet d'accélérer les cinétiques d'oxydation et de classer les matériaux en une durée d'essai de quelques heures, au lieu de plusieurs dizaines d'heures.

Le Tableau 2 ci-après présente les mesures d'épaisseur de chacune des couches de revêtement avant et après chauffage. Les épaisseurs de dépôt sont caractérisées au moyen du calotest.

**Tableau 2 - épaisseurs de revêtement avant et après chauffage**

| Matériau de revêtement | Epaisseur totale initiale (en µm) | Epaisseur totale après 2 h de chauffage à 350°C (en µm) |
|---|---|---|
| CrN | 2,7 | 2,7 |
| WC (ref WC0) | 2,1 | 2,1 |
| Acier | - | - |
| WC(N) (ref WC1) | 2,2 | 2,1 |
| WC(N) (ref WC2) | 2,1 | 2,1 |
| WC(N) (ref WC3) | 2,3 | 2,3 |
| WC(N) (ref WC4) | 2,4 | 2,4 |
| DLC type a-C:H | 3,0 | 0,8 |

Hormis le DLC, toutes les couches de revêtement présentent la même épaisseur après chauffage (à la précision près de mesure), ce qui indique que leur oxydation est insignifiante. Par ailleurs, ceci est confirmé par le fait que leur aspect visuel reste inchangé. La température et la durée sont trop basses pour que l'oxydation ne soit décelable. A l'inverse, l'intégralité du dépôt DLC a-C:H a disparu par oxydation. Il ne reste en place que la sous-couche de type WCC qui sert à l'accroche du DLC. L'examen visuel de l'éprouvette suffit à mettre en évidence l'oxydation et la disparition du DLC, puisque la surface initialement noire a pris un éclat métallique après oxydation.

Le Tableau 3 ci-après présente les caractéristiques des revêtements déterminées grâce aux différents essais ci-dessus. En particulier, on présente l'évolution du coefficient de frottement entre les vitesses de glissement de 50 mm/s et 300 mm/s, ainsi que la résistance des revêtements à une température modérée de 350°C.

**Tableau 3 - caractéristiques des revêtements**

| Matériau de revêtement | Cf à 50 mm/s | Cf à 300 mm/s | Résistance à l'oxydation à 350 °C | Conformité |
|---|---|---|---|---|
| CrN | 0,140 | 0,126 | Oui | NC |
| WC (ref 0) | 0,135 | 0,123 | Oui | NC |
| Acier | 0,135 | 0,121 | NA | NC |
| WC(N) (ref 1) | 0,130 | 0,118 | Oui | NC |
| WC(N) (ref 2) | 0,132 | 0,095 | Oui | C |
| WC(N) (ref 3) | 0,145 | 0,097 | Oui | C |
| WC(N) (ref 4) | 0,142 | 0,093 | Oui | C |
| DLC type a-C:H | 0,118 | 0,014 | Non | NC |

Les revêtements de CrN, WC non dopé à l'azote (ref WC0), WC(N) faiblement dopé à l'azote (ref WC1) sont des couches dures non conformes à l'invention. Le frottement en milieu lubrifié ne conduit pas à la réduction du frottement par rapport à de l'acier poli, non revêtu. Ces matériaux sont à mêmes de résister à une température modérée de 350°C.

Le revêtement de DLC, largement utilisé en milieu lubrifié, n'est pas non plus conforme à l'invention. En effet, la réduction du frottement en milieu lubrifié est spectaculaire, mais l'exposition à une température de 350°C conduit à la destruction du revêtement par oxydation.

Les revêtements de WC(N) de références WC2, WC3 et WC4 sont conformes à l'invention. Contrairement au WC non dopé ou faiblement dopé, on observe une forte réduction du frottement en milieu lubrifié. Bien que cette réduction ne soit pas aussi spectaculaire que pour le DLC, ces matériaux présentent l'avantage de ne pas subir de dégradation par exposition à une température de 350°C.

L'homme du métier comprendra que caractéristiques techniques des différents modes de réalisation et variantes mentionnés dans la description ci-dessus peuvent être, en totalité ou pour certaines d'entre elles, combinées entre elles. Ainsi, la pièce de frottement 10 peut être adaptée en termes de coût, de fonctionnalités et de performance.

## Revendications

1. Pièce de frottement (10), comportant une surface métallique (12) et une couche de revêtement externe (14), **caractérisée en ce que** la couche de revêtement externe (14) est composée de carbure de tungstène dopé à l'azote WC(N) avec entre 5 et 12 % atomique d'azote,
la couche de revêtement externe (14) consistant en:
- entre 40 et 43 % atomique de carbone,
- entre 40 et 43 % atomique de tungstène,
- entre 5 et 12 % atomique d'azote,
- entre 7 et 9% atomique de cobalt,
- d'autres composés pour un total compris entre 0 et 8 % atomique.

2. Pièce de frottement (10) selon la revendication 1, **caractérisée en ce que** la surface métallique (12) est revêtue uniquement avec la couche de revêtement externe (14).

3. Pièce de frottement (10) selon la revendication 1, **caractérisée en ce que** la surface métallique (12) est revêtue avec au moins une sous-couche (18) formée sous la couche de revêtement externe (14).

4. Pièce de frottement selon la revendication 3, **caractérisée en ce que** la sous-couche (18) est composée de chrome ou de nitrure de chrome.

5. Système mécanique (1), comprenant :
- une première pièce de frottement (10) selon l'une quelconque des revendications 1 à 4,
- une seconde pièce de frottement (20) disposée en contact lubrifié avec la première pièce de frottement (10) ;
- un lubrifiant (3) disposé à une interface de contact lubrifié (2) entre les pièces de frottement (10 ; 20).

6. Système mécanique (1) selon la revendication 5, **caractérisé en ce que** la seconde pièce de frottement (20) comporte une surface métallique (22) disposée directement en contact lubrifié avec la première pièce de frottement (10).

7. Système mécanique (1) selon la revendication 5, **caractérisé en ce que** la seconde pièce de frottement (20) comporte une surface métallique (22) et une couche de revêtement externe (24) déposée sur la surface métallique (22), la couche de revêtement externe (24) de la seconde pièce de frottement (20) étant composée de carbure de tungstène dopé à l'azote WC(N) avec entre 5 et 12 % atomique d'azote, la couche de revêtement externe (24) consistant en:
- entre 40 et 43 % atomique de carbone,
- entre 40 et 43 % atomique de tungstène,
- entre 5 et 12 % atomique d'azote,
- entre 7 et 9% atomique de cobalt,
- d'autres composés pour un total compris entre 0 et 8 % atomique.

8. Système mécanique (1) selon la revendication 7, **caractérisé en ce que** la couche de revêtement externe (14) de la première pièce de frottement (10) et la couche de revêtement externe (24) de la seconde pièce de frottement (20) ont la même composition.

9. Procédé de mise en oeuvre d'une pièce de frottement (10) selon l'une quelconque des revendications 1 à 4, **caractérisé en ce que** le procédé comprend des étapes consistant à :
- disposer une seconde pièce de frottement (20) en contact lubrifié avec la pièce de frottement (10) ;
- disposer un lubrifiant (3) à une interface de contact lubrifié (2) entre les pièces de frottement (10 ; 20) ; et
- actionner les pièces de frottement (10 ; 20), de sorte que l'interface de contact lubrifié (2) entre les pièces de frottement (10 ; 20) atteint une température supérieure à 200 °C.

## Patentansprüche

1. Reibungsteil (10) mit einer metallischen Oberfläche (12) und einer äußeren Beschichtungsschicht (14), **gekennzeichnet dadurch, dass** die äußere Beschichtungsschicht (14) aus stickstoffdotiertem Wolframkarbid WC(N) mit einem Stickstoffgehalt zwischen 5 und 12 Atom-% besteht,
die äußere Beschichtungsschicht (14) aus folgenden Bestandteilen besteht:
• zwischen 40 und 43 Atom-% Kohlenstoff,
• zwischen 40 und 43 Atom-% Wolfram,
• zwischen 5 und 12 Atom-% Stickstoff,
• zwischen 7 und 9 Atom-% Kobalt,
• anderen Verbindungen, die insgesamt zwischen 0 und 8 Atom-% ausmachen.

2. Reibungsteil (10) nach Anspruch 1, **gekennzeichnet dadurch, dass** die metallische Oberfläche (12) ausschließlich mit der äußeren Beschichtungsschicht (14) beschichtet ist.

3. Reibungsteil (10) nach Anspruch 1, **gekennzeichnet dadurch, dass** die metallische Oberfläche (12) mit zumindest einer Unterbeschichtung (18) beschichtet ist, die unterhalb der äußeren Beschichtungsschicht (14) gebildet wird.

4. Reibungsteil nach Anspruch 3, **gekennzeichnet dadurch, dass** die Unterbeschichtung (18) aus Chrom oder Chromnitrid besteht.

5. Mechanisches System (1) umfassend:
• ein erstes Reibungsteil (10) gemäß einem der Ansprüche 1 bis 4,
• ein zweites Reibungsteil (20), das in geschmiertem Kontakt mit dem ersten Reibungsteil (10) angeordnet ist;
• ein Schmiermittel (3), das an einer geschmierten Kontaktstelle (2) zwischen den Reibungsteilen (10; 20) angebracht ist.

6. Mechanisches System (1) nach Anspruch 5, **gekennzeichnet dadurch, dass** das zweite Reibungsteil (20) eine metallische Oberfläche (22) hat, die direkt in geschmiertem Kontakt mit dem ersten Reibungsteil (10) steht.

7. Mechanisches System (1) nach Anspruch 5, **gekennzeichnet dadurch, dass** das zweite Reibungsteil (20) eine metallische Oberfläche (22) und eine äußere Beschichtungsschicht (24) auf der metallischen Oberfläche (22) aufweist, wobei die äußere Beschichtungsschicht (24) des zweiten Reibungsteils (20) aus stickstoffdotiertem Wolframkarbid WC(N) mit einem Stickstoffgehalt zwischen 5 und 12 Atom-% besteht und die äußere Beschichtungsschicht (24) aus folgenden Bestandteilen besteht:
• zwischen 40 und 43 Atom-% Kohlenstoff,
• zwischen 40 und 43 Atom-% Wolfram,
• zwischen 5 und 12 Atom-% Stickstoff,
• zwischen 7 und 9 Atom-% Kobalt,
• anderen Verbindungen, die insgesamt zwischen 0 und 8 Atom-% ausmachen.

8. Mechanisches System (1) nach Anspruch 7, **gekennzeichnet dadurch, dass** die äußere Beschichtungsschicht (14) des ersten Reibungsteils (10) und die äußere Beschichtungsschicht (24) des zweiten Reibungsteils (20) die gleiche Zusammensetzung haben.

9. Verfahren zur Umsetzung eines Reibungsteils (10) gemäß einem der Ansprüche 1 bis 4, **gekennzeichnet durch** Schritte, die Folgendes umfassen:
• Anordnen eines zweiten Reibungsteils (20) in geschmiertem Kontakt mit dem Reibungsteil (10);
• Aufbringen eines Schmiermittels (3) an einer geschmierten Kontaktstelle (2) zwischen den Reibungsteilen (10; 20); und
• Betreiben der Reibungsteile (10; 20), sodass die geschmierte Kontaktstelle (2) zwischen den Reibungsteilen (10; 20) eine Temperatur von über 200°C erreicht.

## Claims

1. Friction part (10), comprising a metallic surface (12) and an outer coating layer (14), **characterized in that** the outer coating layer (14) is composed of nitrogen-doped tungsten carbide WC(N) with between 5 and 12 atomic % of nitrogen, the outer coating layer (14) consists of:
• between 40 and 43 atomic % of carbon,
• between 40 and 43 atomic % of tungsten,
• between 5 and 12 atomic % of nitrogen,
• between 7 and 9 atomic % of cobalt,
• other compounds totaling between 0 and 8 atomic %.

2. Friction part (10) according to claim 1, **characterized in that** the metallic surface (12) is coated solely with the outer coating layer (14).

3. Friction part (10) according to claim 1, **characterized in that** the metallic surface (12) is coated with at least one sub-layer (18) formed beneath the outer coating layer (14).

4. Friction part according to claim 3, **characterized in that** the sub-layer (18) is composed of chrome or chrome nitride.

5. Mechanical system (1) comprising:
• a first friction part (10) according to any one of claims 1 to 4,
• a second friction part (20) arranged in lubricated contact with the first friction part (10);
• a lubricant (3) arranged at a lubricated contact interface (2) between the friction parts (10; 20).

6. Mechanical system (1) according to claim 5, **characterized in that** the second friction part (20) has a metallic surface (22) directly in lubricated contact with the first friction part (10).

7. Mechanical system (1) according to claim 5, **characterized in that** the second friction part (20) has a metallic surface (22) and an outer coating layer (24) deposited on the metallic surface (22), wherein the outer coating layer (24) of the second friction part (20) is composed of nitrogen-doped tungsten carbide WC(N) with between 5 and 12 atomic % of nitrogen, and the outer coating layer (24) consists of:
• between 40 and 43 atomic % of carbon,
• between 40 and 43 atomic % of tungsten,
• between 5 and 12 atomic % of nitrogen,
• between 7 and 9 atomic % of cobalt,
• other compounds totaling between 0 and 8 atomic %.

8. Mechanical system (1) according to claim 7, **characterized in that** the outer coating layer (14) of the first friction part (10) and the outer coating layer (24) of the second friction part (20) have the same composition.

9. Method for implementing a friction part (10) according to any one of claims 1 to 4, **characterized in that** the method comprises steps of:
• arranging a second friction part (20) in lubricated contact with the friction part (10);
• placing a lubricant (3) at a lubricated contact interface (2) between the friction parts (10; 20); and
• operating the friction parts (10; 20) so that the lubricated contact interface (2) between the friction parts (10; 20) reaches a temperature higher than 200°C.
